# EUROPEAN PATENT SPECIFICATION

(11) **EP 4 075 044 B1**
(45) Date of publication and mention of the grant of the patent: **11.12.2024**
(21) Application number: 20913146.5
(22) Date of filing: 12.10.2020
(51) Int. Cl.: F16L 29/02, H05K 7/20, F16L 37/30

(54) **LIQUID CONNECTION PLUG, LIQUID CONNECTION ASSEMBLY, AND DEVICE INTERCONNECTION SYSTEM**
FLÜSSIGKEITSVERBINDUNGSSTECKER, FLÜSSIGKEITSVERBINDUNGSANORDNUNG UND GERÄTEVERBINDUNGSSYSTEM
BOUCHON DE RACCORDEMENT DE LIQUIDE, ENSEMBLE DE RACCORDEMENT DE LIQUIDE ET SYSTÈME D'INTERCONNEXION DE DISPOSITIF

(30) Priority: 14.01.2020 CN 202010038447
(43) Date of publication of application: 19.10.2022
(73) Proprietor: Huawei Technologies Co., Ltd., Shenzhen, Guangdong 518129, (CN)
(72) Inventor: PENG, Huan, Shenzhen, Guangdong 518129 (CN); GONG, Xinhu, Shenzhen, Guangdong 518129 (CN); LUO, Rujiang, Shenzhen, Guangdong 518129 (CN)
(74) Representative: Gill Jennings & Every LLP
(86) International application number: PCT/CN2020/120379
(87) International publication number: WO 2021/143220

(56) References cited:
- EP-A1- 2 298 406
- EP-A2- 2 312 118
- WO-A1-98/26835
- CN-A- 101 111 282
- CN-A- 101 111 282
- CN-A- 103 699 194
- CN-A- 109 802 268
- CN-A- 111 255 967
- US-A- 5 065 783
- US-A- 5 083 588
- US-A- 5 488 972
- US-A1- 2004 074 541

## Description

This application claims priority to Chinese Patent Application No. 202010038447.3, filed with the China National Intellectual Property Administration on January 14, 2020 and entitled "LIQUID CONNECTOR, LIQUID CONNECTOR ASSEMBLY, AND DEVICE INTERCONNECTION SYSTEM".

### TECHNICAL FIELD

This application relates to the field of heat dissipation and cooling technologies, and in particular, to a liquid connector, a liquid connector assembly, and a device interconnection system.

### BACKGROUND

In a server in an electronics industry, a communications industry, or the like, a power device such as an electronic chip is first assembled on a server board, then a plurality of server boards are assembled in a cabinet body of the server, and power consumption of the power device such as the electronic chip is increasingly high. Compared with air cooling, liquid cooling can implement heat dissipation of high power consumption, and has an advantage of a relatively good heat dissipation effect. Therefore, it is a development trend to use liquid cooling to perform heat dissipation and cooling on a server board in the cabinet. In an existing liquid cooling and heat dissipation cabinet, a liquid cooling medium supplies liquid to each server board through a liquid distribution pipe, and recycles, through a liquid collection pipe, a liquid cooling medium obtained after heat exchange is performed on each server board. Specifically, a liquid inlet of each server board is connected to the liquid distribution pipe through a connector assembly, and a liquid outlet of each server board is also connected to the liquid collection pipe through a connector assembly. Usually, the connector assembly includes two pluggable connector ends. One of the two connector ends is connected to the server board, and the other connector end is connected to the liquid distribution pipe or the liquid collection pipe.

However, the existing connector assembly has the following technical problem: After a valve plug in the connector end connected to the liquid distribution pipe or the liquid collection pipe fails, if the connector end whose valve plug fails is not connected to the other connector end in a plug manner, the liquid cooling medium in the liquid distribution pipe or the liquid collection pipe leaks from the liquid outlet of the connector end. This causes liquid leakage and liquid spraying, and possibly causes a short circuit of the server board or even burning of the server board.

US 2004/074541 A1 discloses a flow connector comprising first and second flowpath components engageable in an engagement direction.

EP 2 298 406 A1 discloses A connector assembly with a first connector having an outer tube and an inner tube, the outer tube being equipped with a pin having a first flow path, the inner tube being equipped with a first valve element for opening and closing a the first flow path; a second connector having a second flow path and a second valve element for opening and closing the second flow path; a locking means for interconnecting.

WO 98/26835 A1 discloses a closed system, spikeless, positive-flow valve device including a body defining an internal cavity.

US 5 488 972 A discloses an environmental coupling that reduces spillage to less than 1 mL.

US 5 083 588 A discloses a device, incorporating rotating valves, for coupling pipes, wherein the control mechanism associated with the valves of the two elements of the device, is arranged so that rotation of said valves, during approach of the two support plates, is effected sequentially.

US 5 065 783 A discloses a valve insert including an elongated cannula with first and second sharp ends.

### SUMMARY

Embodiments of this application provide a liquid connector according to the appended claims so as to ensure that no liquid leakage occurs in the liquid connector when a valve plug of the liquid connector fails.

To achieve the foregoing objectives, the following technical solutions are used in the embodiments of this application.

According to a first aspect, this application provides a liquid connector, including:
a fastening base;
a connector body, fastened to the fastening base;
a valve plug in the connector body;
a sealing sleeve, located on a side that is of the fastening base and close to a front end of the connector body, where the sealing sleeve is sleeved outside the connector body, and along an insertion direction of the connector body, a rear end of the sealing sleeve is connected to the connector body in a sealed manner, an opening is disposed at a front end of the sealing sleeve, the sealing sleeve can move between a first state and a second state relative to the fastening base along the insertion direction of the connector body, when the sealing sleeve is in the first state, the sealing sleeve is sleeved outside the front end of the connector body, and when the sealing sleeve is in the second state, the front end of the connector body is exposed from the opening to the outside of the sealing sleeve; and
a sealing door, disposed at the opening, and configured to open the opening before the front end of the connector body is exposed from the opening to the outside of the sealing sleeve, and close the opening after the sealing sleeve is sleeved outside the front end of the connector body.

An embodiment of this application provides the liquid connector. In addition to the connector body and the fastening base, the liquid connector further includes the sealing sleeve and the sealing door. Because the sealing sleeve can move between the first state and the second state in the insertion direction of the connector body relative to the fastening base, the sealing door is disposed at the opening. The sealing door is configured to open the opening before the front end of the connector body is exposed from the opening to the outside of the sealing sleeve, and close the opening after the sealing sleeve is sleeved outside the front end of the connector body. Therefore, when the liquid connector is not connected to another liquid connector in a plug manner, that is, when the sealing sleeve is sleeved outside the front end of the connector body, if a valve plug in the connector body fails, because the sealing door closes the opening, leaked liquid does not leak to the outside of the liquid connector, but leaks to an internal space of the sealing sleeve. Therefore, the liquid connector provided in this embodiment of this application can avoid a phenomenon that liquid leakage occurs when the valve plug fails. In addition, when the liquid connector is connected to the another liquid connector in a plug manner, the front end of the connector body may be exposed, to connect to the another liquid connector in a plug manner.

In a possible implementation of the first aspect, the sealing sleeve is of a structure that is telescopic along an insertion direction of the connector body, and a rear end of the sealing sleeve is fastened to the fastening base; and when the sealing sleeve is in the first state, the front end of the sealing sleeve is located on a side that is of the front end of the connector body and that is away from the fastening base, so that the sealing sleeve is sleeved outside the front end of the connector body; or when the sealing sleeve is in the second state, the sealing sleeve shrinks, and the front end of the sealing sleeve is located on a side that is of the front end of the connector body and that is close to the fastening base, so that the front end of the connector body is exposed from the opening to the outside of the sealing sleeve. The sealing sleeve uses the telescopic structure. During specific implementation, the sealing sleeve may be pushed to shrink through an external force, and the first elastic resetting member is used to reset the sealing sleeve. Certainly, the sealing sleeve may also be telescopic by using another structure.

In a possible implementation of the first aspect, the sealing sleeve includes a sealing sleeve body made of a flexible material and a sliding block made of a rigid material, one end of the first elastic resetting member is connected to the sliding block, the other end is connected to the fastening base, and the sealing door is connected to the sliding block.

In a possible implementation of the first aspect, the sealing sleeve includes a first sleeve and a second sleeve that are both made of the rigid material, the first sleeve is fastened to the fastening base, the second sleeve is slidably disposed inside or outside the first sleeve, the sealing door is connected to the second sleeve, one end of the first elastic resetting member is connected to the second sleeve, and the other end is connected to the fastening base.

In a possible implementation of the first aspect, the sealing sleeve is of a rigid structure, and the sealing sleeve is slidably connected to the connector body along an insertion direction of the connector body. When the sealing sleeve is in the first state, the front end of the sealing sleeve is located on a side that is of the front end of the connector body and that is away from the fastening base, and the rear end of the sealing sleeve is located on a side that is of the front end of the connector body and that is close to the fastening base, so that the sealing sleeve is sleeved outside the front end of the connector body. When the sealing sleeve is in the second state, both the front end and the rear end of the sealing sleeve are located on a side that is of the front end of the connector body and that is close to the fastening base, so that the front end of the connector body is exposed to the outside of the sealing sleeve from the opening. The sealing sleeve is slidably connected relative to the connector body, to move between the first state and the second state. During specific implementation, the sealing sleeve may be pushed to slide from the first state to the second state through an external force, and the first elastic resetting member is used to reset the sealing sleeve. Certainly, the sealing sleeve may also slide by using another structure.

In a possible implementation of the first aspect, when a front end face of the sealing sleeve is subject to extrusion pressure, the sealing sleeve can move from the first state to the second state; and the liquid connector further includes: a first elastic resetting member, connected to the sealing sleeve, and configured to apply an elastic resetting force to the sealing sleeve to reset the sealing sleeve from the second state to the first state. In this embodiment of this application, preferably, push force is used to enable the sealing sleeve to move from the first state to the second state. For example, when the liquid connector is connected to another liquid connector in a plug manner, the another liquid connector may apply extrusion pressure to the liquid connector, and the sealing sleeve moves from the second state to the first state by using the first elastic resetting member. In this way, no dedicated drive structure needs to be disposed to drive the sealing sleeve to move. Therefore, the structure is simple and easy to implement.

In a possible implementation of the first aspect, the apparatus further includes a guide structure, configured to guide the sealing sleeve to move between the first state and the second state, where a guide direction of the guide structure is parallel to an insertion direction of the connector body. Through guiding of the guide structure, the sealing sleeve is prevented from being stuck in a process of moving between the first state and the second state.

In a possible implementation of the first aspect, the sealing door is rotatably connected to the sealing sleeve by using the rotating shaft; and the liquid connector further includes an opening/closing assembly, where the opening/closing assembly is configured to drive the sealing door to rotate around the rotating shaft, to open/close the opening. When the sealing sleeve is rotatably connected to the sealing sleeve by using the rotating shaft, the sealing door is opened or closed by using the opening/closing assembly, so as to open/close the sealing door.

In a possible implementation of the first aspect, the opening/closing assembly includes: a transmission gear, fastened relative to the sealing door, where an axis of the transmission gear is collinear with an axis of the rotating shaft; a push rod, slidably connected to the sealing sleeve along the insertion direction of the connector body, where the push rod has engagement teeth disposed along a sliding direction of the push rod, the engagement teeth are engaged with the transmission gear, and the push rod can slide, relative to the sealing sleeve and along the sliding direction of the push rod, from a first position to a second position in a direction close to the fastening base, so as to drive, by engaging the engagement teeth with the transmission gear, the sealing door to rotate from a state in which the opening is closed to a state in which the opening is opened; and a second elastic resetting member, connected to the push rod, where the second elastic resetting member is configured to apply an elastic resetting force to the push rod to drive the push rod to reset from the second position to the first position, so as to drive, by engaging the engagement teeth with the transmission gear, the sealing door to rotate from a state in which the opening is opened to a state in which the opening is closed. In a process in which the push rod slides towards the second position, the push rod drives the transmission gear to rotate in a first rotation direction, where the rotating transmission gear drives the sealing door to rotate around the rotating shaft, so as to open the sealing door, so that the opening is in the open state. When the sealing door needs to be closed, the second elastic resetting member applies an elastic resetting force to the push rod, so that the push rod slides from the second position to the first position, and drives the transmission gear to rotate in a direction opposite to the first rotation direction, thereby driving the sealing door to rotate around the rotating shaft in a direction opposite to the first rotation direction, to close the sealing door, so that the opening is in the closed state.

In a possible implementation of the first aspect, a front end wall of the sealing sleeve is a rotary shell, the sealing door is a rotary shell adapting to the front end wall of the sealing sleeve, and both a rotary axis of the sealing door and a rotary axis of the front end wall of the sealing sleeve are collinear with the axis of the rotating shaft. Both the front end of the sealing sleeve and the sealing door are set to a rotary structure. When the sealing door rotates around the rotating shaft to the open state, the sealing door wraps an outer surface of the connector body. In this way, a length of the entire liquid connector can be reduced, and interference between the sealing door and the sealing sleeve can be avoided when the sealing door is opened.

In a possible implementation of the first aspect, both the front end of the sealing sleeve and the sealing door are spherically shell-shaped.

In a possible implementation of the first aspect, the sealing door is rotatably connected to the sealing sleeve by using the rotating shaft, and when the sealing door moves from the first state to the second state, the sealing door can rotate around the rotating shaft from a state in which the opening is closed to a state in which the opening is opened under push of the front end of the connector body; and the liquid connector further includes: a third elastic resetting member, connected to the sealing door, where the third elastic resetting member is configured to apply an elastic resetting force to the sealing door to drive the sealing door to rotate around the rotating shaft from a state in which the opening is opened to a state in which the opening is closed. When the sealing door needs to be opened, in a process in which the sealing sleeve moves from the first state to the second state, the connector body applies a push force opposite to the movement direction of the sealing sleeve to the sealing door, and the sealing door rotates around the rotating shaft along the first rotation direction to open the sealing door, so that the opening is in the open state. When the sealing door needs to be closed, in a process in which the sealing sleeve moves from the second state to the first state, the push force exerted by the connector body on the sealing door disappears, and the sealing door rotates in a direction opposite to the first rotation direction under an action of the third elastic resetting piece, to close the sealing door, so that the opening is in the closed state. The structure is simple because the connector body exerts an action force on the sealing door to open the sealing door.

In a possible implementation of the first aspect, the sealing door is fastened to the sealing sleeve, and the sealing door is made of an elastic material. The sealing door is set as an elastic sealing door. In a process in which the sealing sleeve moves from the first state to the second state, the connector body applies a push force opposite to the movement direction of the sealing sleeve to open the sealing door, so that the opening is in the open state. In a process in which the sealing sleeve moves from the second state to the first state, the push force exerted by the connector body to the sealing door disappears, and the sealing door restores to an original state by using elasticity of the connector body. In this way, the sealing door is closed, so that the opening is in the closed state. In this way, the opening/closing assembly is not required. This further simplifies a structure of the entire connector. Certainly, the elastic sealing door may also be opened or closed by using the opening/closing assembly.

In a possible implementation of the first aspect, the sealing door includes a first door body and a second door body that are side-by-side bodies.

In a possible implementation of the first aspect, the apparatus further includes: a discharge pipe, where the discharge pipe is in communication with an internal space of the sealing sleeve. The liquid accumulated in the internal space of the sealing sleeve can be discharged in time by disposing the discharge pipe.

According to a second aspect, this application further provides a liquid connector assembly, including:
a first liquid connector, where the first liquid connector is the liquid connector according to any embodiment of the first aspect, a sealing door of the first liquid connector is in an open state, a sealing sleeve of the first liquid connector is in a second state, and a front end of a connector body of the first liquid connector is exposed from the opening to the outside of the sealing sleeve; and
a second liquid connector, where the second liquid connector is connected to the front end of the connector body in a plug manner.

According to the liquid connector assembly provided in this embodiment of this application, because the connector assembly includes the liquid connector in any one of the foregoing technical solutions, when the first liquid connector and the second liquid connector of the liquid connector assembly are not connected in a plug manner, if a valve plug of the first liquid connector fails and a liquid leakage phenomenon occurs, because the sealing door closes the opening, the leaked liquid does not leak to the outside of the liquid connector, but leaks to the internal space of the sealing sleeve. The liquid connector assembly provided in this embodiment of this application can avoid a phenomenon that liquid leakage occurs when the valve plug fails. In addition, when the first liquid connector is connected to the second liquid connector in a plug manner, the front end of the connector body may be exposed, to connect to the second liquid connector in a plug manner.

According to a third aspect, this application further provides a device interconnection system, including:
a first device;
a second device; and
a liquid connector assembly, where the liquid connector assembly is the liquid connector assembly according to the second aspect, a first liquid connector of the liquid connector assembly is disposed on the first device, and a second liquid connector of the liquid connector assembly is disposed on the second device.

According to the device interconnection system provided in this embodiment of this application, because the liquid connector assembly in the implementation of the second aspect is used in the device interconnection system, the device interconnection system provided in this embodiment of this application and the liquid connector assembly in the foregoing technical solution can resolve a same technical problem and achieve a same expected effect.

In a possible implementation of the third aspect, the first device is a cabinet body, the second device is a server board, and the server board is inserted into the cabinet body. The liquid connector assembly is configured to implement a refrigerant liquid connection between the first device and the second device, and the liquid connector assembly is disposed between a front end of the server board along an insertion direction of the server board and the cabinet body. The insertion direction between the server board and the cabinet body is consistent with an insertion direction between the first liquid connector and the second liquid connector. That is, when the second liquid connector is not connected to the first liquid connector in a plug manner, the liquid cooling medium does not leak and flow to the server board due to a failure of the valve plug in the first liquid connector, thereby causing damage to the server board.

### BRIEF DESCRIPTION OF DRAWINGS

FIG. 1 is a schematic diagram of a structure of a device interconnection system according to an embodiment of this application;
FIG. 2 is a schematic diagram of a structure of a sealing sleeve in a first state according to an embodiment of this application;
FIG. 3 is a schematic diagram of a structure of a sealing sleeve in a second state according to an embodiment of this application;
FIG. 4 is a schematic diagram of a structure of a liquid connector assembly when the liquid connector assembly is not connected according to an embodiment of this application;
FIG. 5 is an M-M sectional view of FIG. 4;
FIG. 6 is a schematic diagram of an internal structure of a first liquid connector according to an embodiment of this application;
FIG. 7 is a schematic diagram of a structure of a first liquid connector according to an embodiment of this application;
FIG. 8 is a schematic diagram of a structure in FIG. 7 after a sealing sleeve is removed;
FIG. 9 is a schematic diagram of a structure a liquid connector assembly when the liquid connector assembly is not connected according to an embodiment of this application;
FIG. 10 is a schematic diagram of a structure of a liquid connector assembly after the liquid connector assembly shown in FIG. 9 is connected;
FIG. 11 is a schematic diagram of a structure of a liquid connector assembly when the liquid connector assembly is not connected according to an embodiment of this application;
FIG. 12 is a schematic diagram of a structure of a liquid connector assembly after the liquid connector assembly shown in FIG. 11 is connected;
FIG. 13 is a schematic diagram of a structure of a liquid connector assembly when the liquid connector assembly is not connected according to an embodiment of this application; and
FIG. 14 is a schematic diagram of a structure of a liquid connector assembly after the liquid connector assembly shown in FIG. 13 is connected.

### Reference numerals:

1-first device; 2-second device; 3-liquid cooling system; 4-liquid connector assembly; 41-first liquid connector; 411-first connector body; A1-first conversion end; B 1-first connector end; 412- fastening base; 42-second liquid connector; 421-second connector body; 422-protective sleeve; 423-push block; A2-second conversion end; B2-second connector end; 5-sealing sleeve; 51-sealing sleeve body made of a flexible material; 52-sliding block; 53-first sleeve; 54-second sleeve; 6-sealing door; 61-first door body; 62-second door body; 7-discharge pipe; 8-rotating shaft; 9-transmission gear; 10-push rod; 11-first elastic resetting part; 12-second elastic resetting part; 13-guide structure; and 14-third elastic resetting part.

### DESCRIPTION OF EMBODIMENTS

Embodiments of this application relate to a device interconnection system, a liquid connector assembly, and a liquid connector for detailed description.

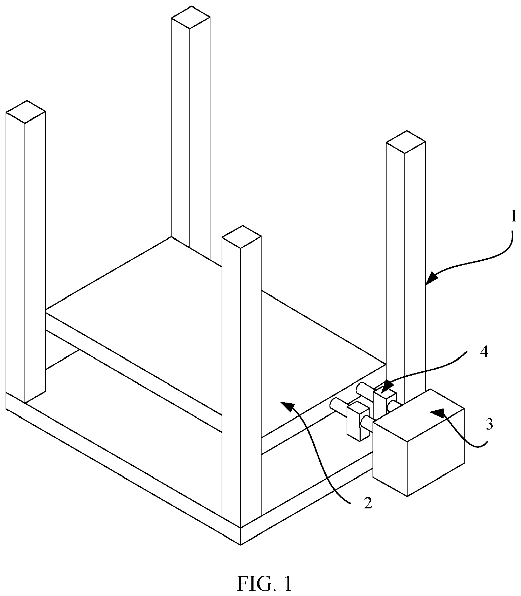

In one aspect, an embodiment of this application provides a device interconnection system. Refer to FIG. 1. The device interconnection system includes a first device 1, a second device 2, and a liquid connector assembly 4. A first liquid connector of the liquid connector assembly 4 is disposed on the first device 1, and a second liquid connector of the liquid connector assembly 4 is disposed on the second device 2. In other words, the liquid connector assembly 4 is used to implement a refrigerant liquid connection between the first device and the second device.

In some implementations, the first device 1 may be a cabinet body, and the second device 2 may be a server board. The cabinet body has a liquid inlet pipe and a liquid return pipe that are connected to a liquid cooling system 3. The liquid inlet pipe is connected to a liquid inlet of the server board through the liquid connector assembly 4, and the liquid return pipe is also connected to a liquid return port of the server board through the liquid connector assembly 4. The server board is inserted into the cabinet body, and the liquid connector assembly is disposed between the cabinet body and a front end of the server board in an insertion direction of the server board. The insertion direction between the server board and the cabinet body is consistent with an insertion direction between the first liquid connector and the second liquid connector.

A working principle of the device interconnection system for performing heat dissipation and cooling on the server board is as follows: A liquid cooling medium enters a flow channel of the server board through the liquid connector assembly 4 and the liquid inlet of the server board in sequence. The liquid cooling medium performs heat exchange in the flow channel, and the liquid cooling medium after the heat exchange flows out through the liquid outlet of the server board and the liquid connector assembly 4 in sequence. In this way, heat dissipation and cooling of the server board are implemented, so as to ensure use performance of components on the server board and prevent a relatively high temperature from affecting normal running of the components.

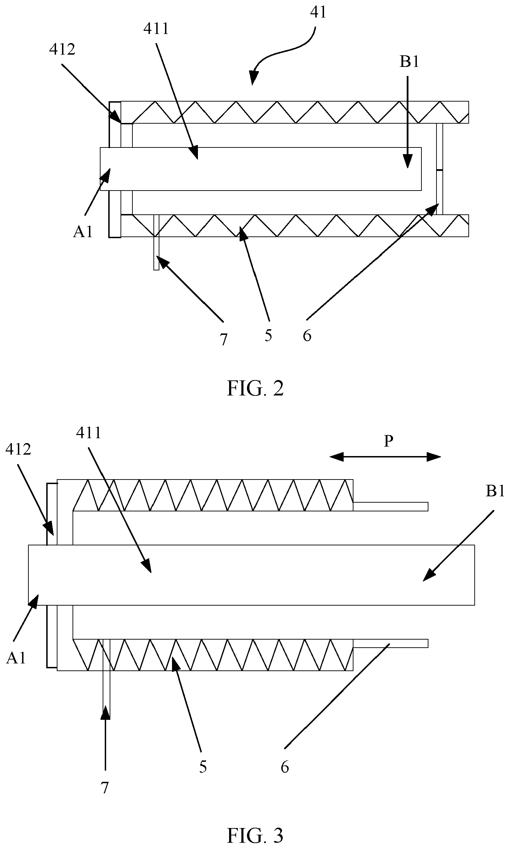

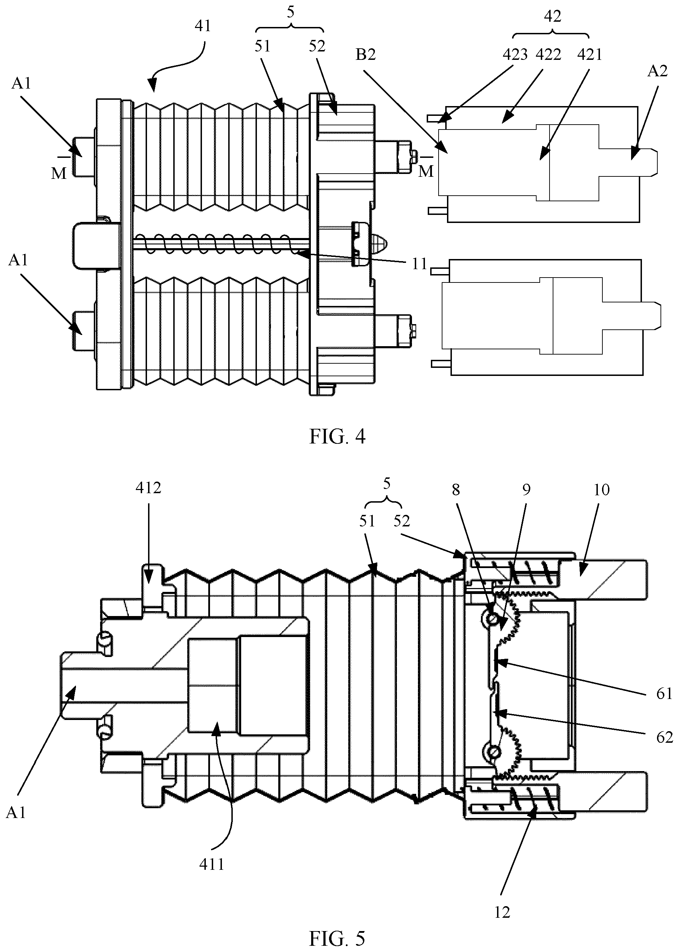

In another aspect, an embodiment of this application provides a liquid connector assembly, to improve working performance of the liquid connector assembly while ensuring that quick plug-connection can be implemented. Refer to FIG. 2, FIG. 3, FIG. 4, and FIG. 5. The liquid connector assembly 4 includes a first liquid connector 41 and a second liquid connector 42 that are pluggable, and the first liquid connector 41 includes a first connector body 411 and a fastening base 412 configured to fasten the first connector body 411. The first connector body 411 has a first conversion end A1 and a first connector end B 1 having a valve plug inside. The first connector body 411 is connected to a liquid inlet pipe and a liquid return pipe on the cabinet body, or the server board by using the first conversion end A1. The first connector end B1 is configured to be connected to the second liquid connector 42 in a plug manner. Refer to FIG. 4. The second liquid connector 42 includes a second connector body 421, a protective sleeve 422, and a push block 423 connected to the protective sleeve 422. The second connector body 421 has a second conversion end A2 and a second connector end B2 having a valve plug inside, and the second connector end B2 of the second connector body 421 is configured to connect to the first connector body 411 in a plug manner. The second connector body 421 is connected to the liquid inlet pipe and the liquid return pipe on the cabinet body, or the server board by using the second conversion end A2. The second connector body 421 is slidably disposed in the protective sleeve 422.

In addition, the second liquid connector 42 may include only the second connector body 421, or may include other structures than the second connector body 421, the protective sleeve 422, and the push block 423. A specific structure of the second liquid connector 42 is not limited herein, and any structure falls within the protection scope of this application.

It should be noted that, the first connector body 411 and the fastening base 412 for fastening the first connector body 411 may be two independent parts, or may also be an integrally formed structure.

In use, when the first liquid connector 41 and the second liquid connector 42 are not connected in a plug manner, and the valve plug in the first connector end B1 of the first liquid connector 41 fails and a liquid leakage phenomenon occurs, the leaked liquid may flow to the server board, thereby causing damage to the server board.

To avoid a phenomenon that liquid leakage occurs when the second liquid connector 42 is not connected to the first liquid connector 41 in a plug manner and the valve plug in the first liquid connector 41 fails, according to still another aspect, an embodiment of this application provides a first liquid connector. Refer to FIG. 2 and FIG. 3. In addition to the first connector body 411 and the fastening base 412, the first liquid connector 41 further includes a sealing sleeve 5 and a sealing door 6. The sealing sleeve 5 is located on one side that is of the fastening base 412 and that is close to a front end (that is, one end close to the first connector end) of the first connector body 411, and the sealing sleeve 5 is sleeved outside the first connector body 411. Along an insertion direction of the first connector body 411, a rear end (that is, one end close to the first conversion end) of the sealing sleeve 5 is connected to the first connector body 411 in a sealed manner, and an opening is disposed at a front end of the sealing sleeve 5. The sealing sleeve 5 can move between the first state and the second state in an insertion direction P of the connector body relative to the fastening base 412. When the sealing sleeve 5 is in the first state, the sealing sleeve 5 is sleeved outside the front end (that is, the first connector end) of the first connector body 411. When the sealing sleeve 5 is in the second state, the front end of the first connector body 411 is exposed from the opening to the sealing sleeve 5, and the sealing door 6 is disposed at the opening, configured to: open the opening before the front end of the first connector body 411 is exposed to the outside of the sealing sleeve 5 from the opening, and close the opening after the sealing sleeve 5 is sleeved outside the front end of the first connector body 411.

It should be noted that, in this embodiment, the front end of the first connector body 411 refers to the first connector end, a rear end of the first connector body 411 refers to the first conversion end, the front end of the sealing sleeve 5 refers to one end close to the first connector end, and the rear end of the sealing sleeve 5 refers to one end close to the first conversion end.

When the sealing sleeve 5 is in the first state, that is, when the first liquid connector 41 is not connected to the second liquid connector 42 in a plug manner, the sealing door 6 is closed, that is, the sealing door 6 seals the opening of the sealing sleeve 5. If the valve plug in the first ferrule fails and a liquid leakage phenomenon occurs, the leaked liquid flows into internal space of the sealing sleeve 5, but does not flow out of the entire first liquid connector 41. The first liquid connector provided in this embodiment of this application can still ensure that the first liquid connector does not leak when the valve plug fails, and the leaked liquid does not damage the server board.

The first liquid connector 41 provided in this embodiment of this application can still be quickly connected to the second liquid connector 42 in a plug manner. For example, when the first liquid connector 41 needs to be connected to the second liquid connector 42 in a plug manner, the first liquid connector 41 and the second liquid connector 42 are close to each other, the sealing sleeve 5 moves from the first state to the second state, and the front end of the first connector body is exposed outside the sealing sleeve 5 from the opening, and is connected to the second liquid connector 42 in a plug manner. For another example, when the first liquid connector 41 and the second liquid connector 42 that are connected in a plug manner need to be disconnected, the first liquid connector 41 and the second liquid connector 42 are relatively far away from each other, and the sealing sleeve 5 moves from the second state to the first state. When the sealing sleeve 5 moves to the first state, the first connector end B 1 of the first liquid connector 41 moves into the sealing sleeve 5, the sealing door 6 is closed, and the opening is blocked.

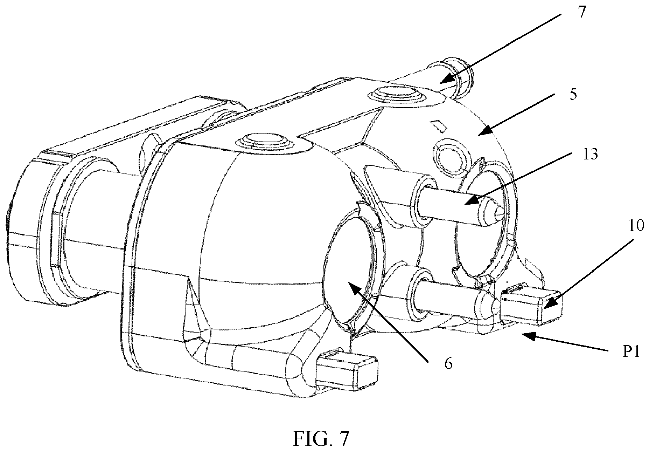

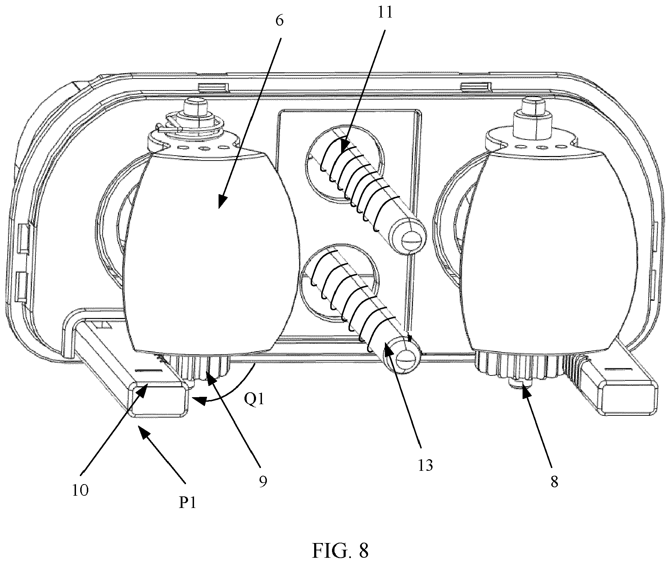

The sealing sleeve 5 moves between the first state and the second state in a plurality of implementations. In some implementations, refer to FIG. 4 to FIG. 6 and FIG. 9. The sealing sleeve 5 is of a structure that is telescopic along the insertion direction of the first connector body. The rear end of the sealing sleeve 5 is fastened to the fastening base 412. When the sealing sleeve 5 is in the first state, the front end of the sealing sleeve 5 is located on a side that is of the front end of the first connector body and that is away from the fastening base 412, so that the sealing sleeve 5 is sleeved outside the front end of the first connector body. When the sealing sleeve 5 is in the second state, the sealing sleeve 5 shrinks, and the front end of the sealing sleeve is located on a side that is of the front end of the first connector body and that is close to the fastening base, so that the front end of the first connector body is exposed outside the sealing sleeve 5 from the opening, that is, movement between the first state and the second state is implemented through extension. In some other implementations, refer to FIG. 7 and FIG. 8. The sealing sleeve 5 is of a rigid structure, and the sealing sleeve 5 is slidably connected to the first connector body along the insertion direction of the first connector body. When the sealing sleeve 5 is in the first state, the front end of the sealing sleeve 5 is located on a side that is of the front end of the first connector body and that is away from the fastening base, and the rear end of the sealing sleeve 5 is located on a side that is of the front end of the first connector body and that is close to the fastening base, so that the sealing sleeve is sleeved outside the front end of the first connector body. When the sealing sleeve 5 is in the second state, both the front end and the rear end of the sealing sleeve are located on a side that is of the front end of the first connector body and that is close to the fastening base, so that the front end of the first connector body is exposed outside the sealing sleeve from the opening, that is, the sealing sleeve is slidably connected to the connector body, to implement movement between the first state and the second state.

A drive force that drives the sealing sleeve 5 to move in the first state and the second state may be implemented in a plurality of manners. In some implementations, the sealing sleeve may be driven to move by using a drive structure. The drive structure is an electric drive structure (for example, a linear motor), a hydraulic drive structure (for example, a hydraulic cylinder), or a pneumatic drive structure (for example, a cylinder). In some other implementations, when a front end face of the sealing sleeve is subject to extrusion pressure, the sealing sleeve can shrink from the first state to the second state. The liquid connector further includes: a first elastic resetting member 11, connected to the sealing sleeve, and configured to apply an elastic reset force to the sealing sleeve, so that the sealing sleeve is reset from the second state to the first state.

When the first liquid connector 41 is connected to the second liquid connector 42 in a plug manner, the first liquid connector 41 and the second liquid connector 42 generate relative motion, and a push force of the second liquid connector 42 may be used to enable the sealing sleeve to move from the first state to the second state. Therefore, in this application, no drive structure is used, and the push force of the second liquid connector 42 is preferably used to enable the sealing sleeve to move from the first state to the second state. This simplifies a structure of the entire connector and facilitates implementation.

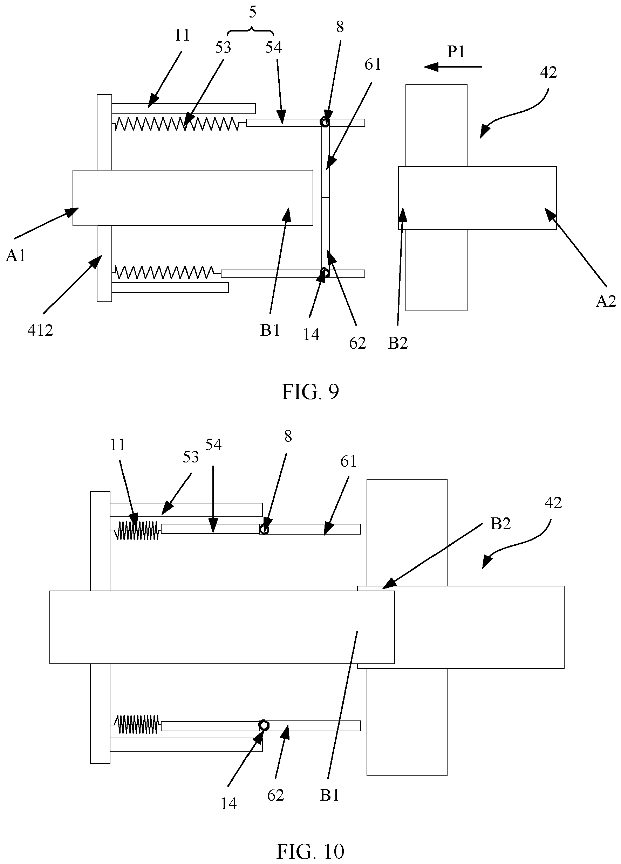

There are a plurality of cases in which the sealing sleeve 5 is a structure that is telescopic along the insertion direction of the first connector body. In some implementations, refer to FIG. 4 to FIG. 6. The sealing sleeve 5 includes a sealing sleeve body 51 made of a flexible material and a sliding block 52 made of a rigid material. One end of the first elastic resetting member is connected to the sliding block 52, the other end is connected to the fastening base 412, and the sealing door is connected to the sliding block. That is, movement between the first state and the second state is implemented through extension of the sealing sleeve body 51 made of the flexible material. In some other implementations, as shown in parameter FIG. 9, the sealing sleeve 5 includes a first sleeve 53 and a second sleeve 54 that are both made of a rigid material, the first sleeve 53 is fastened to the fastening base 412, the second sleeve 54 is slidably disposed inside or outside the first sleeve 53, the sealing door 6 is connected to the second sleeve 54, one end of the first elastic resetting member 11 is connected to the second sleeve 54, and the other end is connected to the fastening base 412, that is, extension is implemented by using the first sleeve and the second sleeve that are slidably cooperated with each other.

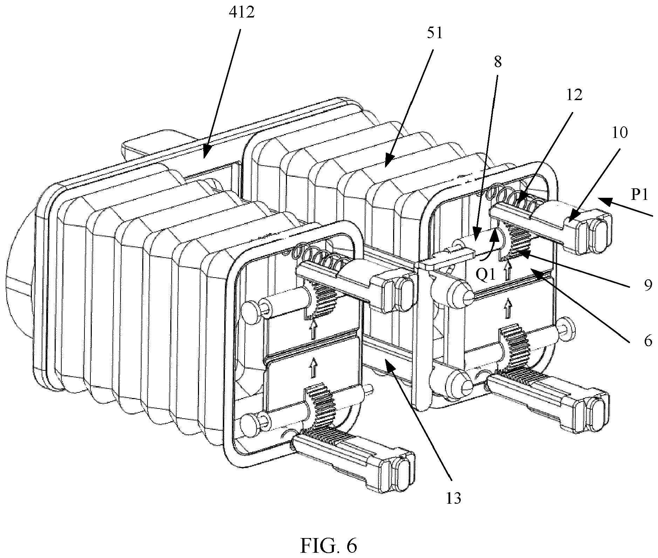

To guide the sealing sleeve 5 to move between the first state and the second state, refer to FIG. 6. A guide structure 13 is further included, and a guide direction of the guide structure 13 is parallel to an insertion direction of the first connector body. The guide structure has a plurality of implementable structures. For example, the guide structure is a guide column, and the sealing sleeve is slidably connected to a guide column. Certainly, the guide structure may alternatively be another structure, for example, a guide rail and a sliding block that match each other. A specific structure of the guide structure is not limited herein.

To prevent the sealing sleeve from sliding out of the guide column, the sealing sleeve further includes a limiting structure. The limiting structure is configured to prevent the sealing sleeve from sliding out of the guide column. For example, a boss is formed at an end of a limiting column, to prevent the sealing sleeve from sliding out. A specific structure of the limiting structure is not limited herein either. When the guide structure is a guide column, and the first elastic resetting member is a spring, the spring may be sleeved on the guide column.

Refer to FIG. 5 and FIG. 6. The sealing door may be rotatably connected to the sealing sleeve by using the rotating shaft 8. The liquid connector further includes an opening/closing assembly, where the opening/closing assembly is configured to drive the sealing door to rotate around the rotating shaft 8, so as to open/close the opening. The sealing door may be made of a rigid material, or may be made of an elastic material. When the sealing door is rotatably connected to the sealing sleeve by using the rotating shaft, the sealing door is opened or closed by using the opening/closing component, to open/close the sealing door. As shown in FIG. 5, FIG. 6, and FIG. 7 to FIG. 8, the sealing door is rotatably connected to the sealing sleeve by using the rotating shaft 8.

The opening/closing assembly has a plurality of implementation structures. The following describes specific implementations of the opening/closing assembly. In addition to the following described embodiments of the opening/closing assembly, other embodiments also fall within the protection scope of this application.

In some implementations, refer to FIG. 5 and FIG. 6, and FIG. 7 and FIG. 8. The opening/closing assembly includes: a transmission gear 9, a push rod 10, and a second elastic resetting member 12, where the transmission gear 9 is relatively fastened to the sealing door 6, a rotation axis of the transmission gear 9 is collinear with an axis of the rotating shaft 8, the push rod 10 is slidably connected to the sealing sleeve 6 along the plugging direction of the first connector body, the push rod 10 has an engagement teeth disposed along a sliding direction of the push rod 10, the engagement teeth are engaged with the transmission gear 9, and the push rod 10 may slide from a first position to a second position along the sliding direction of the push rod 10 relative to the sealing sleeve 5, so as to drive, by engaging the engagement teeth with the transmission gear 9, the sealing door to rotate from the state in which the opening is closed to the state in which the opening is opened. The second elastic resetting member 12 is connected to the push rod 10, and the second elastic resetting member 12 is configured to apply an elastic resetting force to the push rod 10 to drive the push rod to reset from the second position to the first position, so as to drive, by engaging the engagement teeth with the transmission gear, the sealing door to rotate from the state in which the opening is opened to the state in which the opening is closed. A working principle of the opening/closing assembly is as follows: When the first liquid connector 41 is connected to the second liquid connector 42 in a plug manner, the push rod 10 moves along a direction P1 depending on push of the second liquid connector 42. The moving push rod 10 drives the transmission gear 9 to rotate around a direction Q1, and the rotating transmission gear 9 drives the sealing door 6 to rotate around the rotating shaft 8 until the sealing door 6 opens the opening. When the first liquid connector 41 and the second liquid connector 42 are disconnected, the push rod 10 moves in a direction opposite to the direction P1 under the action of the second elastic resetting member 12, to drive the transmission gear 9 to rotate around the rotating shaft 8 in a direction opposite to the direction Q1, so that the sealing door 6 rotates to the opening to seal and block the opening. In addition, the second elastic resetting member 12 in this embodiment may be a torsion spring, or may be an elastic member such as a tension spring. All structures that have a same function as the torsion spring and the tension spring fall within the protection scope of this application.

In some other implementations, the opening/closing assembly is a rotating motor, an output shaft of the rotating motor is connected to the rotating shaft, and rotation of the rotating motor drives the rotating shaft to rotate, so as to drive the sealing door to rotate around the rotating shaft. In some other implementations, the opening/closing assembly may also be a lead screw mechanism, and the lead screw mechanism drives the push rod to move.

In this application, preferably, the opening/closing assemblies shown in FIG. 5 and FIG. 6 and FIG. 7 and FIG. 8 are used. When the first liquid connector 41 is connected to the second liquid connector 42 in a plug manner, the push rod 10 may be pushed to move through the push force of the second liquid connector 42, to drive the transmission gear 9 to rotate, so as to drive the sealing door to rotate around the rotating shaft. Compared with that of the rotating motor, energy consumption can be reduced, and costs can be reduced.

The sealing door 6 may be opened or closed in various directions. Refer to FIG. 7 and FIG. 8. An axis of the rotating shaft 8 is arranged along a radial direction of the first connector body 411, that is, the axis of the rotating shaft 8 passes through the first connector body 411. In this way, when the opening is in an open state, the sealing door rotates between the first connector body 411 and the sealing sleeve 5. Refer to FIG. 5 and FIG. 6. The axis of the rotating shaft 8 is arranged along a tangent direction of the first connector body 411, that is, the axis of the rotating shaft 8 is located outside the first connector body 411. In this way, the sealing door rotates in a direction away from the first connector body 411 to open the opening.

A front end wall of the sealing sleeve 5 shown in FIG. 7 and FIG. 8 is a rotary shell, the sealing door 6 is a rotary shell adapting to the front end wall of the sealing sleeve 5, and both a rotary axis of the sealing door 6 and a rotary axis of the front end wall of the sealing sleeve 5 are collinear with the axis of the rotating shaft 8. Both the front end wall of the sealing sleeve and the sealing door are set to a rotary structure. When the sealing door rotates around the rotating shaft to the open state, the sealing door wraps an outer surface of the connector body. In this way, a length of the entire liquid connector can be reduced, and interference between the sealing door and the sealing sleeve can be avoided when the sealing door is opened. For example, both the front end of the sealing sleeve 5 and the sealing door 6 are spherical shells or cylindrical shells.

To enable the sealing door to open the opening before the front end of the connector body is exposed outside the sealing sleeve from the opening, and to close the opening after the sealing sleeve is sleeved outside the front end of the connector body, when the elastic force of the second elastic resetting member is less than that of the first elastic resetting member, a technical effect achieved in this way is: When the first liquid connector and the second liquid connector are connected in a plug manner, the sealing door is first opened, and then the sealing sleeve moves from the first state to the second state; and when the first liquid connector and the second liquid connector are disconnected, the sealing sleeve moves from the second state to the first state, and then the sealing door is closed. In this way, the plug-connection is performed after the sealing door is opened, and the sealing door can be effectively closed only after the sealing sleeve is reset, so as to achieve an anti-leakage effect.

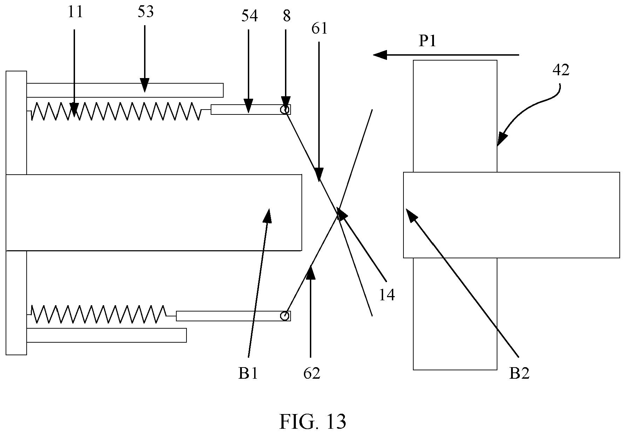

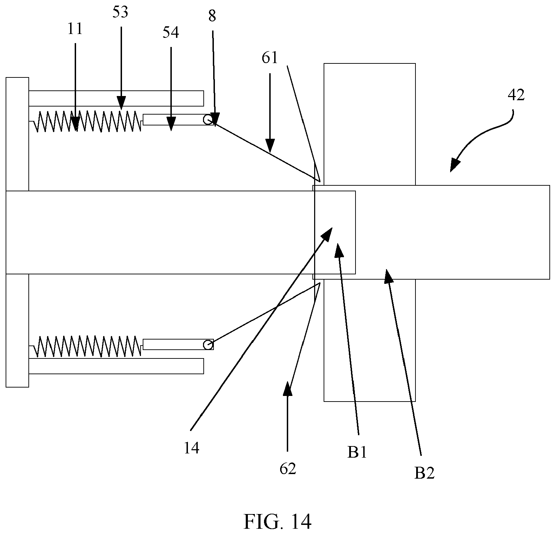

In some implementations, refer to FIG. 9, FIG. 10, FIG. 13, and FIG. 14. The sealing door 6 is made of a rigid material. When the sealing door 6 moves from a first state to a second state, the sealing door 6 can rotate around the rotating shaft 8 from the state in which the opening is closed to the state in which the opening is opened under push of the front end of the first connector body. The liquid connector further includes: a third elastic resetting member 14, connected to the sealing door, where the third elastic resetting member 14 is configured to apply an elastic resetting force to the sealing door to drive the sealing door to rotate around the rotating shaft from the state in which the opening is opened to the state in which the opening is closed. When the sealing door needs to be opened, in a process in which the sealing sleeve moves from the first state to the second state, the first connector body applies a push force opposite to the movement direction of the sealing sleeve to the sealing door, and the sealing door rotates around the rotating shaft along the first rotation direction to open the sealing door, so that the opening is in the open state. When the sealing door needs to be closed, in a process in which the sealing sleeve moves from the second state to the first state, the push force exerted by the connector body on the sealing door disappears, and the sealing door rotates in a direction opposite to the first rotation direction under an action of the third elastic resetting piece, to close the sealing door, so that the opening is in the closed state. The structure is simple because the connector body exerts an action force on the sealing door to open the sealing door. In addition, the third elastic resetting member in this embodiment may be a torsion spring, or may be an elastic member such as a tension spring. All structures that have a same function as the torsion spring and the tension spring fall within the protection scope of this application.

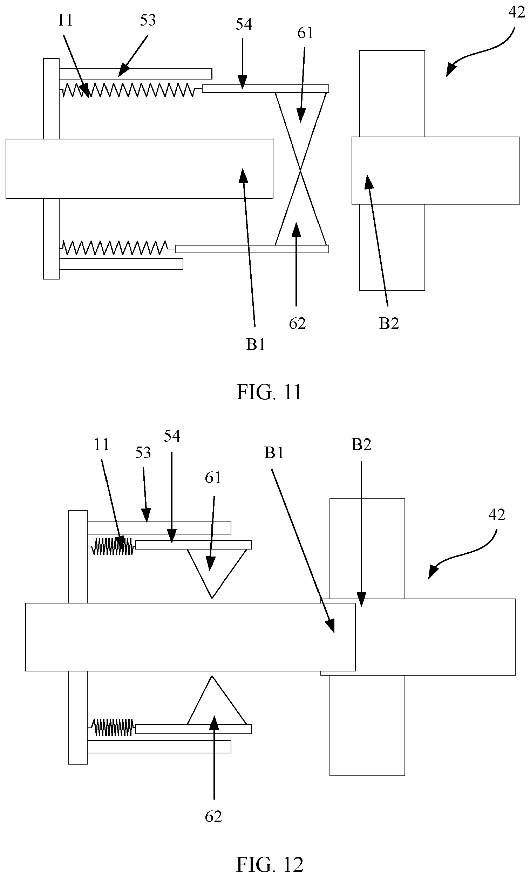

In some implementations, refer to FIG. 11 and FIG. 12. The sealing door is made of an elastic material, and the sealing door is fastened to the sealing sleeve. That is, when a first liquid connector body of the first liquid connector 41 or a second liquid connector body of the second liquid connector 42 exerts a push force on the sealing door, the sealing door shrinks in a direction close to an inner wall of the sealing sleeve 5 under elastic force of the sealing door, so as to open the opening. When the first liquid connector 41 and the second liquid connector 42 are disconnected, the push force exerted by the first liquid connector body of the first liquid connector 41 on the sealing door disappears, and the sealing door extends, under the elastic force of the sealing door, in a direction away from the inner wall of the sealing sleeve 5 to restore to a free state, so as to close the opening.

When the sealing door is made of an elastic material, a material of the sealing door may be plastic or another polymer material, and any elastic sealing door falls within the protection scope of this application.

Refer to FIG. 7 and FIG. 8. The sealing door 6 may include a door body. Refer to FIG. 9 and FIG. 10. The sealing door 6 includes a first door body 61 and a second door body 62 that are opposite to each other. When the sealing door 6 includes an opening/closing assembly, there are two groups of opening/closing assemblies, and there are two rotating shafts. One group of opening/closing assemblies is used to open/close the first door body, and the other group of opening/closing assemblies is used to open/closing the second door body. Compared with that of one door body, an advantage of disposing the first door body and the second door body that are opposite each other is that avoidance space of the sealing sleeve may be reduced, so that a structure of the entire liquid connector is more compact.

To further improve working performance of the liquid connector, refer to FIG. 2 and FIG. 3. A discharge pipe 7 is further included, and the discharge pipe 7 communicates with internal space of the sealing sleeve 5. The liquid accumulated in the internal space of the sealing sleeve can be discharged in time through the discharge pipe 7, so as to avoid excessive liquid accumulated in the internal space of the sealing sleeve.

In some implementations, the liquid connector includes at least two connector bodies, and all the connector bodies are fastened to one fastening base. Refer to FIG. 6 and FIG. 7. When a liquid inlet of a liquid inlet pipe on the cabinet body is relatively close to a liquid return port of the liquid return pipe, the liquid connector provided in this embodiment may be used. During specific implementation, one-time plug-connection may not only implement plug-connection of the liquid connector corresponding to the liquid inlet pipe, but also implement plug-connection of the liquid connector corresponding to the liquid return pipe. This improves plug-connection efficiency.

## Claims

1. A liquid connector (41), comprising:
a fastening base (412);
a connector body (411), fastened to the fastening base;
a sealing sleeve (5), located on a side that is of the fastening base and close to a front end of the connector body, wherein the sealing sleeve is sleeved outside the connector body, and along an insertion direction of the connector body, a rear end of the sealing sleeve is connected to the connector body in a sealed manner, an opening is disposed at a front end of the sealing sleeve, the sealing sleeve can move between a first state and a second state relative to the fastening base along the insertion direction of the connector body, when the sealing sleeve is in the first state, the sealing sleeve is sleeved outside the front end of the connector body, and when the sealing sleeve is in the second state, the front end of the connector body is exposed from the opening to the outside of the sealing sleeve; and
a sealing door (6), disposed at the opening, and configured to open the opening before the front end of the connector body is exposed from the opening to the outside of the sealing sleeve, and close the opening after the sealing sleeve is sleeved outside the front end of the connector body,
**characterized in that** the liquid connector comprises a valve plug in the connector body.

2. The liquid connector according to claim 1, wherein the sealing sleeve is a structure that is telescopic along an insertion direction of the connector body, and a rear end of the sealing sleeve is fastened to the fastening base;
when the sealing sleeve is in the first state, the front end of the sealing sleeve is located on a side that is of the front end of the connector body and that is away from the fastening base, so that the sealing sleeve is sleeved outside the front end of the connector body; and
when the sealing sleeve is in the second state, the sealing sleeve shrinks, and the front end of the sealing sleeve is located on a side that is of the front end of the connector body and that is close to the fastening base, so that the front end of the connector body is exposed from the opening to the outside of the sealing sleeve.

3. The liquid connector according to claim 1, wherein the sealing sleeve is of a rigid structure, and the sealing sleeve is slidably connected to the connector body along an insertion direction of the connector body;
when the sealing sleeve is in the first state, the front end of the sealing sleeve is located on a side that is of the front end of the connector body and that is away from the fastening base, and the rear end of the sealing sleeve is located on a side that is of the front end of the connector body and that is close to the fastening base, so that the sealing sleeve is sleeved outside the front end of the connector body; and
when the sealing sleeve is in the second state, both the front end and the rear end of the sealing sleeve are located on a side that is of the front end of the connector body and that is close to the fastening base, so that the front end of the connector body is exposed from the opening to the outside of the sealing sleeve.

4. The liquid connector according to any one of claims 1 to 3, wherein when a front end face of the sealing sleeve is subject to extrusion pressure, the sealing sleeve can move from the first state to the second state; and
the liquid connector further comprises:
a first elastic resetting member (11), connected to the sealing sleeve, and configured to apply an elastic resetting force to the sealing sleeve to reset the sealing sleeve from the second state to the first state.

5. The liquid connector according to any one of claims 1 to 4, further comprising:
a guide structure (13), configured to guide the sealing sleeve to move between the first state and the second state, wherein a guide direction of the guide structure is parallel to the insertion direction of the connector body.

6. The liquid connector according to any one of claims 1 to 5, wherein the sealing door is rotatably connected to the sealing sleeve by using a rotating shaft (8); and
the liquid connector further comprises:
an opening/closing assembly, wherein the opening/closing assembly is configured to drive the sealing door to rotate around the rotating shaft, so as to open/close the opening.

7. The liquid connector according to claim 6, wherein the opening/closing assembly comprises:
a transmission gear (9), fastened relative to the sealing door, wherein an axis of the transmission gear is collinear with an axis of the rotating shaft;
a push rod (10), slidably connected to the sealing sleeve along the insertion direction of the connector body, wherein the push rod has engagement teeth disposed along a sliding direction of the push rod, the engagement teeth are engaged with the transmission gear, and the push rod can slide, relative to the sealing sleeve and along the sliding direction of the push rod, from a first position to a second position in a direction close to the fastening base, so as to drive, by engaging the engagement teeth with the transmission gear, the sealing door to rotate from a state in which the opening is closed to a state in which the opening is opened; and
a second elastic resetting member (12), connected to the push rod, wherein the second elastic resetting member is configured to apply an elastic resetting force to the push rod to drive the push rod to reset from the second position to the first position, so as to drive, by engaging the engagement teeth with the transmission gear, the sealing door to rotate from a state in which the opening is opened to a state in which the opening is closed.

8. The liquid connector according to claim 6 or 7, wherein a front end wall of the sealing sleeve is a rotary shell, the sealing door is a rotary shell adapting to the front end wall of the sealing sleeve, and both a rotary axis of the sealing door and a rotary axis of the front end wall of the sealing sleeve are collinear with the axis of the rotating shaft.

9. The liquid connector according to any one of claims 1 to 5, wherein the sealing door is rotatably connected to the sealing sleeve by using the rotating shaft, and when the sealing door moves from the first state to the second state, the sealing door can rotate around the rotating shaft from a state in which the opening is closed to a state in which the opening is opened under push of the front end of the connector body; and
the liquid connector further comprises:
a third elastic resetting member (14), connected to the sealing door, wherein the third elastic resetting member is configured to apply an elastic resetting force to the sealing door to drive the sealing door to rotate around the rotating shaft from a state in which the opening is opened to a state in which the opening is closed.

10. The liquid connector according to any one of claims 1 to 5, wherein the sealing door is fastened to the sealing sleeve, and the sealing door is made of an elastic material.

11. The liquid connector according to any one of claims 1 to 10, wherein the sealing door comprises a first door body and a second door body that are opposite to each other.

12. The liquid connector according to any one of claims 1 to 11, further comprising:
a discharge pipe (7), communicating with an internal space of the sealing sleeve.

13. A liquid connector assembly, comprising:
a first liquid connector (41), wherein the first liquid connector is the liquid connector according to any one of claims 1 to 12, a sealing door (6) of the first liquid connector is in a state in which an opening is opened, a sealing sleeve (5) of the first liquid connector is in a second state, and a front end of a connector body (411) of the first liquid connector is exposed from the opening to the outside of the sealing sleeve; and
a second liquid connector (42), wherein the second liquid connector is connected to the front end of the connector body in a plug manner.

14. A device interconnection system, comprising:
a first device (1);
a second device (2); and
a liquid connector assembly (4), wherein the liquid connector assembly is the liquid connector assembly according to claim 13, a first liquid connector of the liquid connector assembly is disposed on the first device, and a second liquid connector of the liquid connector assembly is disposed on the second device.

15. The device interconnection system according to claim 14, wherein the first device is a cabinet body, the second device is a server board, and the server board is inserted into the cabinet body; and
the liquid connector assembly is configured to implement refrigerant liquid connection between the first device and the second device, the liquid connector assembly is disposed between the cabinet body and a front end of the server board in an insertion direction of the server board, and the insertion direction between the server board and the cabinet body is consistent with an insertion direction between the first liquid connector and the second liquid connector.

## Patentansprüche

1. Flüssigkeitsverbinder (41), umfassend:
eine Befestigungsbasis (412);
einen Verbinderkörper (411), der an der Befestigungsbasis befestigt ist;
eine Dichtungshülse (5), die sich auf einer Seite befindet, die der Befestigungsbasis angehört und nahe einem vorderen Ende des Verbinderkörpers liegt, wobei die Dichtungshülse außerhalb des Verbinderkörpers umhüllt ist und entlang einer Einsteckrichtung des Verbinderkörpers ein hinteres Ende der Dichtungshülse in abgedichteter Weise mit dem Verbinderkörper verbunden ist, eine Öffnung an einem vorderen Ende der Dichtungshülse angeordnet ist, sich die Dichtungshülse in Bezug auf die Befestigungsbasis entlang der Einsteckrichtung des Verbinderkörpers zwischen einem ersten Zustand und einem zweiten Zustand bewegen kann, wenn sich die Dichtungshülse in dem ersten Zustand befindet, die Dichtungshülse außerhalb des vorderen Endes des Verbinderkörpers umhüllt ist und, wenn sich die Dichtungshülse in dem zweiten Zustand befindet, das vordere Ende des Verbinderkörpers von der Öffnung zu der Außenseite der Dichtungshülse freigelegt ist; und
eine Dichtungstür (6), die an der Öffnung angeordnet und dazu konfiguriert ist, die Öffnung zu öffnen, bevor das vordere Ende des Verbinderkörpers von der Öffnung zu der Außenseite der Dichtungshülse freigelegt ist, und die Öffnung zu schließen, nachdem die Dichtungshülse außerhalb des vorderen Endes des Verbinderkörpers umhüllt ist,
**dadurch gekennzeichnet, dass** der Flüssigkeitsverbinder einen Ventilstecker in dem Verbinderkörper aufweist.

2. Flüssigkeitsverbinder nach Anspruch 1, wobei die Dichtungshülse eine Struktur ist, die entlang einer Einsteckrichtung des Verbinderkörpers teleskopisch ist, und ein hinteres Ende der Dichtungshülse an der Befestigungsbasis befestigt ist;
wenn sich die Dichtungshülse in dem ersten Zustand befindet, sich das vordere Ende der Dichtungshülse auf einer Seite befindet, die dem vorderen Ende des Verbinderkörpers angehört und von der Befestigungsbasis weg weist, sodass die Dichtungshülse außerhalb des vorderen Endes des Verbinderkörpers umhüllt ist; und
wenn sich die Dichtungshülse in dem zweiten Zustand befindet, die Dichtungshülse schrumpft und sich das vordere Ende der Dichtungshülse auf einer Seite befindet, die dem vorderen Ende des Verbinderkörpers angehört und die nahe der Befestigungsbasis liegt, sodass das vordere Ende des Verbinderkörpers von der Öffnung zu der Außenseite der Dichtungshülse freigelegt ist.

3. Flüssigkeitsverbinder nach Anspruch 1, wobei die Dichtungshülse aus einer starren Struktur besteht und die Dichtungshülse entlang einer Einsteckrichtung des Verbinderkörpers gleitbar mit dem Verbinderkörper verbunden ist;
wenn sich die Dichtungshülse in dem ersten Zustand befindet, sich das vordere Ende der Dichtungshülse auf einer Seite befindet, die dem vorderen Ende des Verbinderkörpers angehört und die von der Befestigungsbasis weg weist, und sich das hintere Ende der Dichtungshülse auf einer Seite befindet, die dem vorderen Ende des Verbinderkörpers angehört und die nahe der Befestigungsbasis liegt, sodass die Dichtungshülse außerhalb des vorderen Endes des Verbinderkörpers umhüllt ist; und
wenn sich die Dichtungshülse in dem zweiten Zustand befindet, sich sowohl das vordere Ende als auch das hintere Ende der Dichtungshülse auf einer Seite befindet, die dem vorderen Ende des Verbinderkörpers angehört und die nahe der Befestigungsbasis liegt, sodass das vordere Ende des Verbinderkörpers von der Öffnung zu der Außenseite der Dichtungshülse freigelegt ist.

4. Flüssigkeitsverbinder nach einem der Ansprüche 1 bis 3, wobei, wenn eine vordere Endfläche der Dichtungshülse einem Extrusionsdruck ausgesetzt ist, sich die Dichtungshülse von dem ersten Zustand in den zweiten Zustand bewegen kann; und der Flüssigkeitsverbinder ferner Folgendes umfasst:
ein erstes elastisches Rückstellelement (11), das mit der Dichtungshülse verbunden und dazu konfiguriert ist, eine elastische Rückstellkraft auf die Dichtungshülse anzuwenden, um die Dichtungshülse von dem zweiten Zustand in den ersten Zustand zurückzustellen.

5. Flüssigkeitsverbinder nach einem der Ansprüche 1 bis 4, ferner umfassend:
eine Führungsstruktur (13), die dazu konfiguriert ist, die Dichtungshülse dazu zu führen, sich zwischen dem ersten Zustand und dem zweiten Zustand zu bewegen, wobei eine Führungsrichtung der Führungsstruktur parallel zu der Einsteckrichtung des Verbinderkörpers verläuft.

6. Flüssigkeitsverbinder nach einem der Ansprüche 1 bis 5, wobei die Dichtungstür drehbar mit der Dichtungshülse unter Verwendung einer Drehwelle (8) verbunden ist; und
der Flüssigkeitsverbinder ferner Folgendes umfasst:
eine Öffnungs-/Schließungsanordnung, wobei die Öffnungs-/Schließungsanordnung dazu konfiguriert ist, die Dichtungstür dazu anzutreiben, sich um die Drehwelle zu drehen, um die Öffnung zu öffnen/schließen.

7. Flüssigkeitsverbinder nach Anspruch 6, wobei die Öffnungs-/Schließungsanordnung Folgendes umfasst:
ein Übertragungszahnrad (9), das in Bezug auf die Dichtungstür befestigt ist, wobei eine Achse des Übertragungszahnrads kollinear mit einer Achse der Drehwelle ist;
eine Schubstange (10), die entlang der Einsteckrichtung des Verbinderkörpers gleitbar mit der Dichtungshülse verbunden ist, wobei die Schubstange Eingriffszähne aufweist, die entlang einer Gleitrichtung der Schubstange angeordnet sind, die Eingriffszähne mit dem Übertragungszahnrad in Eingriff stehen und die Schubstange in Bezug auf die Dichtungshülse und entlang der Gleitrichtung der Schubstange von einer ersten Position zu einer zweiten Position in einer Richtung nahe der Befestigungsbasis gleiten kann, um durch Eingreifen der Eingriffszähne in das Übertragungszahnrad die Dichtungstür dazu anzutreiben, sich von einem Zustand, in dem die Öffnung geschlossen ist, in einen Zustand, in dem die Öffnung geöffnet ist, zu drehen; und
ein zweites elastisches Rückstellelement (12), das mit der Schubstange verbunden ist, wobei das zweite elastische Rückstellelement dazu konfiguriert ist, eine elastische Rückstellkraft auf die Schubstange anzuwenden, um die Schubstange dazu anzutreiben, sich von der zweiten Position in die erste Position zurückzustellen, um durch Eingreifen der Eingriffszähne in das Übertragungszahnrad die Dichtungstür dazu anzutreiben, sich von einem Zustand, in dem die Öffnung geöffnet ist, in einen Zustand, in dem die Öffnung geschlossen ist, zu drehen.

8. Flüssigkeitsverbinder nach Anspruch 6 oder 7, wobei eine vordere Endwand der Dichtungshülse eine Drehschale ist, die Dichtungstür eine Drehschale ist, die sich an die vordere Endwand der Dichtungshülse anpasst, und sowohl eine Drehachse der Dichtungstür als auch eine Drehachse der vorderen Endwand der Dichtungshülse kollinear mit der Achse der Drehwelle ist.

9. Flüssigkeitsverbinder nach einem der Ansprüche 1 bis 5, wobei die Dichtungstür unter Verwendung der Drehwelle drehbar mit der Dichtungshülse verbunden ist und, wenn sich die Dichtungstür von dem ersten Zustand in den zweiten Zustand bewegt, sich die Dichtungstür unter Druck des vorderen Endes des Verbinderkörpers um die Drehwelle von einem Zustand, in dem die Öffnung geschlossen ist, in einen Zustand, in dem die Öffnung geöffnet ist, drehen kann; und
der Flüssigkeitsverbinder ferner Folgendes umfasst:
ein drittes elastisches Rückstellelement (14), das mit der Dichtungstür verbunden ist, wobei das dritte elastische Rückstellelement dazu konfiguriert ist, eine elastische Rückstellkraft auf die Dichtungstür anzuwenden, um die Dichtungstür dazu anzutreiben, sich um die Drehwelle von einem Zustand, in dem die Öffnung geöffnet ist, in einen Zustand, in dem die Öffnung geschlossen ist, zu drehen.

10. Flüssigkeitsverbinder nach einem der Ansprüche 1 bis 5, wobei die Dichtungstür an der Dichtungshülse befestigt ist und die Dichtungstür aus einem elastischen Material besteht.

11. Flüssigkeitsverbinder nach einem der Ansprüche 1 bis 10, wobei die Dichtungstür einen ersten Türkörper und einen zweiten Türkörper umfasst, die einander gegenüberliegen.

12. Flüssigkeitsverbinder nach einem der Ansprüche 1 bis 11, ferner umfassend:
ein Abflussrohr (7), das mit einem Innenraum der Dichtungshülse in Verbindung steht.

13. Flüssigkeitsverbindungsanordnung, umfassend:
einen ersten Flüssigkeitsverbinder (41), wobei der erste Flüssigkeitsverbinder der Flüssigkeitsverbinder nach einem der Ansprüche 1 bis 12 ist, sich eine Dichtungstür (6) des ersten Flüssigkeitsverbinders in einem Zustand befindet, in dem eine Öffnung geöffnet ist, sich eine Dichtungshülse (5) des ersten Flüssigkeitsverbinders in einem zweiten Zustand befindet und ein vorderes Ende eines Verbinderkörpers (411) des ersten Flüssigkeitsverbinders von der Öffnung zu der Außenseite der Dichtungshülse freigelegt ist; und
einen zweiten Flüssigkeitsverbinder (42), wobei der zweite Flüssigkeitsverbinder in einer Steckerweise mit dem vorderen Ende des Verbinderkörpers verbunden ist.

14. Geräteverbindungssystem, umfassend:
ein erstes Gerät (1);
ein zweites Gerät (2); und
eine Flüssigkeitsverbindungsanordnung (4), wobei die Flüssigkeitsverbindungsanordnung die Flüssigkeitsverbindungsanordnung nach Anspruch 13 ist, ein erster Flüssigkeitsverbinder der Flüssigkeitsverbindungsanordnung an dem ersten Gerät angeordnet ist und ein zweiter Flüssigkeitsverbinder der Flüssigkeitsverbindungsanordnung an dem zweiten Gerät angeordnet ist.

15. Geräteverbindungssystem nach Anspruch 14, wobei das erste Gerät ein Gehäusekörper ist, das zweite Gerät eine Serverplatine ist und die Serverplatine in den Gehäusekörper eingesetzt ist; und
die Flüssigkeitsverbindungsanordnung dazu konfiguriert ist, eine Kühlmittelflüssigkeitsverbindung zwischen dem ersten Gerät und dem zweiten Gerät herzustellen, die Flüssigkeitsverbindungsanordnung zwischen dem Gehäusekörper und einem vorderen Ende der Serverplatine in einer Einsteckrichtung der Serverplatine angeordnet ist und die Einsteckrichtung zwischen der Serverplatine und dem Gehäusekörper mit einer Einsteckrichtung zwischen dem ersten Flüssigkeitsverbinder und dem zweiten Flüssigkeitsverbinder übereinstimmt.

## Revendications

1. Connecteur de liquide (41), comprenant :
une base de fixation (412) ;
un corps de connecteur (411), fixé à la base de fixation ;
un manchon d'étanchéité (5), situé sur un côté qui est de la base de fixation et à proximité d'une extrémité avant du corps de connecteur, dans lequel le manchon d'étanchéité est emmanché à l'extérieur du corps de connecteur, et le long d'une direction d'insertion du corps de connecteur, une extrémité arrière du manchon d'étanchéité est reliée au corps de connecteur de manière étanche, une ouverture est disposée au niveau d'une extrémité avant du manchon d'étanchéité, le manchon d'étanchéité pouvant se déplacer entre un premier état et un second état par rapport à la base de fixation le long de la direction d'insertion du corps de connecteur, lorsque le manchon d'étanchéité est dans le premier état, le manchon d'étanchéité est emmanché à l'extérieur de l'extrémité avant du corps de connecteur, et lorsque le manchon d'étanchéité est dans le second état,
l'extrémité avant du corps de connecteur est exposé depuis l'ouverture vers l'extérieur du manchon d'étanchéité ; et
une porte d'étanchéité (6), disposée au niveau de l'ouverture, et configurée pour ouvrir l'ouverture avant que l'extrémité avant du corps de connecteur ne soit exposée depuis l'ouverture vers l'extérieur du manchon d'étanchéité, et fermer l'ouverture après que le manchon d'étanchéité est emmanché à l'extérieur de l'extrémité avant du corps de connecteur,
**caractérisé en ce que** le connecteur de liquide comprend un bouchon de valve dans le corps de connecteur.

2. Connecteur de liquide selon la revendication 1, dans lequel le manchon d'étanchéité est une structure télescopique le long d'une direction d'insertion du corps de connecteur, et une extrémité arrière du manchon d'étanchéité est fixée à la base de fixation ;
lorsque le manchon d'étanchéité est dans le premier état, l'extrémité avant du manchon d'étanchéité est située sur un côté qui est de l'extrémité avant du corps de connecteur et qui est éloigné de la base de fixation, de sorte que le manchon d'étanchéité est emmanché à l'extérieur de l'extrémité avant du corps de connecteur ; et
lorsque le manchon d'étanchéité est dans le second état, le manchon d'étanchéité se rétrécit, et l'extrémité avant du manchon d'étanchéité est située sur un côté qui est de l'extrémité avant du corps de connecteur et qui est proche de la base de fixation, de sorte que l'extrémité avant du corps de connecteur est exposée depuis l'ouverture vers l'extérieur du manchon d'étanchéité.

3. Connecteur de liquide selon la revendication 1, dans lequel le manchon d'étanchéité est d'une structure rigide, et le manchon d'étanchéité est relié de manière coulissante au corps de connecteur le long d'une direction d'insertion du corps de connecteur ;
lorsque le manchon d'étanchéité est dans le premier état, l'extrémité avant du manchon d'étanchéité est située sur un côté qui est de l'extrémité avant du corps de connecteur et qui est éloigné de la base de fixation, et l'extrémité arrière du manchon d'étanchéité est situé sur un côté qui est de l'extrémité avant du corps de connecteur et qui est proche de la base de fixation, de sorte que le manchon d'étanchéité soit emmanché à l'extérieur de l'extrémité avant du corps de connecteur ; et
lorsque le manchon d'étanchéité est dans le second état, l'extrémité avant et l'extrémité arrière du manchon d'étanchéité sont toutes deux situées sur un côté de l'extrémité avant du corps de connecteur qui est proche de la base de fixation, de sorte que l'extrémité avant du corps de connecteur est exposée depuis l'ouverture vers l'extérieur du manchon d'étanchéité.

4. Connecteur de liquide selon l'une quelconque des revendications 1 à 3, dans lequel lorsqu'une face d'extrémité avant du manchon d'étanchéité est soumise à une pression d'extrusion, le manchon d'étanchéité peut passer du premier état au second état ; et
le connecteur de liquide comprend également :
un premier élément de réinitialisation élastique (11), relié au manchon d'étanchéité, et configuré pour appliquer une force de réinitialisation élastique au manchon d'étanchéité afin de réinitialiser le manchon d'étanchéité du second état au premier état.

5. Connecteur de liquide selon l'une quelconque des revendications 1 à 4, comprenant également :
une structure de guidage (13), configurée pour guider le manchon d'étanchéité afin qu'il se déplace entre le premier état et le second état, dans lequel une direction de guidage de la structure de guidage est parallèle à la direction d'insertion du corps de connecteur.

6. Connecteur de liquide selon l'une quelconque des revendications 1 à 5, dans lequel la porte d'étanchéité est reliée de manière rotative au manchon d'étanchéité à l'aide d'un arbre rotatif (8) ; et
le connecteur de liquide comprend également :
un ensemble d'ouverture/fermeture, dans lequel l'ensemble d'ouverture/fermeture est configuré pour entraîner la porte d'étanchéité à tourner autour de l'arbre rotatif, de manière à ouvrir/fermer l'ouverture.

7. Connecteur de liquide selon la revendication 6, dans lequel l'ensemble d'ouverture/fermeture comprend :
un engrenage de transmission (9), fixé par rapport à la porte d'étanchéité, dans lequel un axe de l'engrenage de transmission est colinéaire à un axe de l'arbre rotatif ;
une tige de poussée (10), reliée de manière coulissante au manchon d'étanchéité le long de la direction d'insertion du corps de connecteur, dans lequel la tige de poussée a des dents de prise disposées le long d'une direction de coulissement de la tige de poussée, les dents de prise sont en prise avec l'engrenage de transmission, et la tige de poussée peut coulisser, par rapport au manchon d'étanchéité et le long de la direction de coulissement de la tige de poussée, d'une première position à une seconde position dans une direction proche de la base de fixation, de manière à entraîner, en mettant en prise des dents de prise avec l' engrenage de transmission, la porte d'étanchéité devant tourner d'un état dans lequel l'ouverture est fermée à un état dans lequel l'ouverture est ouverte ; et
un deuxième élément de réinitialisation élastique (12), relié à la tige de poussée, dans lequel le second élément de réinitialisation élastique est configuré pour appliquer une force de réinitialisation élastique à la tige de poussée pour entraîner la tige de poussée à se réinitialiser de la seconde position à la première position, de manière à entraîner, en mettant en prise les dents de prise avec l'engrenage de transmission, la porte d'étanchéité à tourner d'un état dans lequel l'ouverture est ouverte à un état dans lequel l'ouverture est fermée.

8. Connecteur de liquide selon la revendication 6 ou 7, dans lequel une paroi d'extrémité avant du manchon d'étanchéité est une coque rotative, la porte d'étanchéité est une coque rotative s'adaptant à la paroi d'extrémité avant du manchon d'étanchéité, et à la fois un axe rotatif de la porte d'étanchéité et un axe rotatif de la paroi d'extrémité avant du manchon d'étanchéité sont colinéaires à l'axe de l'arbre rotatif.

9. Connecteur de liquide selon l'une quelconque des revendications 1 à 5, dans lequel la porte d'étanchéité est reliée de manière rotative au manchon d'étanchéité à l'aide de l'arbre rotatif, et lorsque la porte d'étanchéité se déplace du premier état au second état, la porte d'étanchéité peut tourner autour de l'arbre rotatif depuis un état dans lequel l'ouverture est fermée jusqu'à un état dans lequel l'ouverture est ouverte sous la poussée de l'extrémité avant du corps de connecteur ; et
le connecteur de liquide comprend également :
un troisième élément de réinitialisation élastique (14), relié à la porte d'étanchéité, dans lequel le troisième élément de réinitialisation élastique est configuré pour appliquer une force de réinitialisation élastique à la porte d'étanchéité pour entraîner la porte d'étanchéité à tourner autour de l'arbre rotatif à partir d'un état dans lequel l'ouverture est ouverte jusqu'à un état dans lequel l'ouverture est fermée.

10. Connecteur de liquide selon l'une quelconque des revendications 1 à 5, dans lequel la porte d'étanchéité est fixée au manchon d'étanchéité, et la porte d'étanchéité est constituée d'un matériau élastique.

11. Connecteur de liquide selon l'une quelconque des revendications 1 à 10, dans lequel la porte d'étanchéité comprend un premier corps de porte et un second corps de porte qui sont opposés l'un à l'autre.

12. Connecteur de liquide selon l'une quelconque des revendications 1 à 11, comprenant également :
un tuyau d'évacuation (7), communiquant avec un espace interne du manchon d'étanchéité.

13. Ensemble connecteur de liquide, comprenant :
un premier connecteur de liquide (41), dans lequel le premier connecteur de liquide est le connecteur de liquide selon l'une quelconque des revendications 1 à 12, une porte d'étanchéité (6) du premier connecteur de liquide est dans un état dans lequel une ouverture est ouverte, un manchon d'étanchéité (5) du premier connecteur de liquide est dans un second état, et une extrémité avant d'un corps de connecteur (411) du premier connecteur de liquide est exposée depuis l'ouverture vers l'extérieur du manchon d'étanchéité ; et
un second connecteur de liquide (42), dans lequel le second connecteur de liquide est connecté à l'extrémité avant du corps de connecteur de manière à former un bouchon.

14. Système d'interconnexion de dispositif, comprenant :
un premier dispositif (1) ;
un second dispositif (2) ; et
un ensemble connecteur de liquide (4), dans lequel l'ensemble connecteur de liquide est l'ensemble connecteur de liquide selon la revendication 13, un premier connecteur de liquide de l'ensemble connecteur de liquide est disposé sur le premier dispositif, et un second connecteur de liquide de l'ensemble connecteur de liquide est disposé sur le second dispositif.

15. Système d'interconnexion de dispositif selon la revendication 14, dans lequel le premier dispositif est un corps d'armoire, le second dispositif est une carte serveur, et la carte serveur est insérée dans le corps d'armoire ; et
l'ensemble connecteur de liquide est configuré pour mettre en œuvre une connexion de liquide réfrigérant entre le premier dispositif et le second dispositif, l'ensemble connecteur de liquide est disposé entre le corps d'armoire et une extrémité avant de la carte serveur dans une direction d'insertion de la carte serveur, et la direction d'insertion entre la carte serveur et le corps d'armoire est cohérente avec une direction d'insertion entre le premier connecteur de liquide et le second connecteur de liquide.
